# EUROPEAN PATENT APPLICATION

(11) **EP 3 882 372 A1**
(43) Date of publication of application: **22.09.2021**
(21) Application number: 19884840.0
(22) Date of filing: 28.10.2019
(51) Int. Cl.: C23C 14/35, B82Y 40/00

(54) **METHOD FOR OBTAINING A SOLID MATERIAL WITH GASEOUS AGGREGATES BY MEANS OF MAGNETRON CATHODE SPUTTERING IN STATIC OR QUASISTATIC CONDITIONS TO REDUCE THE USE OF GAS**

(30) Priority: 15.11.2018 ES 201831107
(71) Applicant: Consejo Superior de Investigaciones Cientificas, 28006 Madrid (ES)
(72) Inventor: FERNÁNDEZ CAMACHO, Mª Asunción, 41092 Sevilla (ES); HUFSCHMIDT, Dirk, 41092 Sevilla (DE); FORTIO GODINHO, Vanda Cristina, 41092 Sevilla (PT); JIMÉNEZ DE HARO, Mª Carmen, 41092 Sevilla (ES)
(74) Representative: Pons
(86) International application number: PCT/ES2019/070729
(87) International publication number: WO 2020/099695

(57) **Abstract**

The present invention relates to a method for obtaining a solid material with gaseous aggregates embedded therein, wherein the aggregates are embedded inside nanopores and/or in the grain boundaries of the solid, by means of magnetron cathode sputtering, in a static or quasistatic regime. The invention belongs to processes of the metallurgist industry and/or processes for obtaining materials with others embedded (nanocomposites) by means of sputtering.

## Description

The present invention relates to a method for obtaining a solid material with gaseous aggregates embedded therein, wherein the aggregates are embedded inside nanopores and/or in the grain boundaries of the solid, by means of magnetron cathode sputtering, in a static or quasistatic regime. The invention belongs to processes of the metallurgist industry and/or processes for obtaining materials with others embedded (nanocomposites) by means of sputtering.

### BACKGROUND OF THE INVENTION

Layer deposition by means of magnetron cathode sputtering, or "magnetron sputtering", is based on the intense bombardment of a material with the ions produced in an electrical discharge in the form of plasma. When the energy of the incident ions is high enough, the interaction with the surface of the material (through the exchange of the kinetic moment) causes the atoms on the surface to be stripped, to pass to the vapour phase. The stripped atoms travel to the surface of the substrate and there they condense. In general, a working gas under reduced pressure or vacuum is used to produce the discharge. In the vast majority of cases, a certain working pressure is adjusted with a flow of the working gas. A dynamic equilibrium is established with the controlled gas flow and the connection to the vacuum pump. The advantages, a priori, of this method are the easy control of pressure, the constant renewal of the working gas and the elimination of contamination.

Previously, it has been reported that it is possible to manufacture solid materials (typically silicon) with gaseous aggregates (typically He) contained therein by means of magnetron cathode sputtering in a dynamic regime. See references: i) R. Schierholz; B. Lacroix; V. Godinho; J. Caballero-Hernández; M. Duchamp and A. Fernández. "STEM-EELS analysis reveals stable high-density He in nanopores of amorphous silicon coatings deposited by magnetron sputtering". Nanotechnology, Volume 26: Number 7 (2015) 075703. ii) A. Fernández and V. Godinho, Method for obtaining coatings by means of cathode sputtering and coating obtainable by means of said method, ES2347123 (B1).

Likewise, W and C sputtering with Helium has been described in a dynamic regime with incorporation of He (V. Tiron, C. Andrei, A. V. Nastuta, G. B. Rusu, C. Vitelaru and G. Popa, XXIIIrd Int. Symp. on Discharges and Electrical Insulation in Vacuum - Bucharest - 2008).

Given the advantages of the dynamic working method described above, the main drawback thereof is the high consumption of the working gas when using a constant renewal flow of the process gas (typically a flow between 20 ml/min and 120 ml/min). This is an important problem when it is necessary to incorporate into the solid gases which are scarce in nature, and which are expensive, toxic, explosive and/or radioactive. These gases can be, for example, hydrogen, nitrogen or noble gases (helium, neon, etc.) and especially the isotopes thereof (deuterium, tritium, helium-3, neon-21, etc.). Specifically, the materials made up of these isotopes incorporated into a solid matrix could be used to research, for example, the properties of the nuclei far from the stability line ("exotic" nuclei), and in general, to study nuclear reactions.

The standard method in magnetron cathode sputtering deposition always recommends working in a dynamic regime (R.V.Stuart, Vacuum Technology, Thin Films, and Sputtering, Academic Press, 1983) in order to maintain better cleanliness in the deposition chamber. Furthermore, T.H. Baum, C.E. Larson and R.L. Jackson in "Laser-induced chemical vapor deposition of aluminum", Applied Physics Letters 55, 1264 (1989) have described the use of static conditions in a different deposition method, such as the laser-assisted CVD technique (chemical deposition from vapour phase), which moreover has not been applied to obtaining materials that incorporate gas aggregates. Finally, D.W. Hoffman in "A sputtering wind", Journal of Vacuum Science & Technology A 3, 561 (1985) describes a Mo sputtering process with Ar process gas working in a static vacuum regime, but only for the purpose of studying gas convection currents in the chamber. In no case is the effect of the process conditions on the material obtained compared, nor is the methodology related to low-consumption processes for special gases.

There exists, therefore, a need in view of the state of the art that is associated with the high use of working gases, especially in the manufacture of layers containing special gas aggregates, and that to date remains unresolved.

### DESCRIPTION OF THE INVENTION

The present invention relates to a method of layer deposition by magnetron cathode sputtering in static or quasistatic conditions for obtaining a solid material with gas aggregates, wherein said aggregates are embedded inside nanopores and/or in the grain boundaries of the solid. Said method is carried out in a magnetron cathode sputtering deposition chamber in static or quasistatic conditions. The method thus minimises the expenditure of working gas, avoiding constant renewal of the gas.

Additionally, the following advantages of this method of magnetron sputtering deposition in static (or quasistatic) equilibrium have been found with respect to the state of the art:
- the amount of the working gas used in the method of the present invention is reduced with respect to that described by the traditional methods of dynamic gas flow. The use of gas in the process presented herein reaches at most 0.5% of the use in the dynamic regime. This enables the application thereof for working gases which are scarce in nature, expensive, toxic, explosive and/or radioactive.
- the trapped working gas content has values in atoms/cm² that are comparable (even higher in some cases) to the values described when operating in the traditional dynamic flow mode;
- the higher deposition rate that is achieved with the method of the present invention as compared to those described in the state of the art (dynamic);
- the content of impurities and residual contamination in the layers obtained by the method of the present invention is the same or even surprisingly improves in some cases with respect to the methods described in the state of the art for dynamic gas flow.

In a first aspect, the present invention relates to a method for obtaining a solid material with gaseous aggregates wherein said aggregates are embedded inside nanopores and/or in the grain boundaries of the solid, by means of magnetron cathode sputtering in static or quasistatic conditions, characterised in that it is carried out in a deposition chamber comprising
- a magnetron, located in the upper area of the deposition chamber and configured to generate a controllable magnetic field;
- a target, attached to the magnetron, configured to house a solid element to be used as a target;
- a sample holder, located at a distance between 8-10 cm from the target, configured so that a substrate is on it;
- a shutter located between the target and the sample holder and configured to move transversely along the direction between the target and the sample holder;
- a pressure sensor located on one of the sides of the chamber and configured to send a signal that indicates the internal pressure in the chamber;
- a valve located in an inlet pipe to the deposition chamber from a working gas cylinder, configured to control the flow of the working gas entering the deposition chamber;
- a valve connected to an outlet pipe to the vacuum pump, configured to control the gas that comes out to the vacuum pump; and wherein said method comprises the following steps
   (a) introducing a solid element to be used as a target in the magnetron cathode sputtering deposition chamber, and a substrate selected from silicon, NaCl, metal sheets, and SiC, on the sample holder;
   (b) closing all the valves of the deposition chamber and creating a vacuum in the chamber after placing the solid as a target in step (a) up to a pressure of at least 1·10⁻⁴ Pa;
   (c) heating the deposition chamber once the necessary vacuum has been reached in step (b) to a temperature between 80°C and 110°C for a time between 6 h and 8 h, and subsequently allowing it to cool down to a temperature between 10°C and 30°C;
   (d) closing the valve connected to the vacuum pump of the chamber, introducing the working gas in the deposition chamber after the heating step (c) wherein said working gas is selected from ³He, ⁴He, He, ²⁰Ne, ²¹Ne, ²²Ne, Ne, H₂, N₂, Ar and any mixture of the foregoing up to a working pressure between 3 Pa and 7 Pa;
   (e) once the pressure described in the previous step (d) has been reached, and maintaining said working pressure in the chamber, the working gas flow is reduced, fully or partially closing the inlet and outlet valves, to and from the deposition chamber until reaching a flow selected from
      - a flow of zero ml/min; or
      - a flow between 0.001 ml/min and 0.1 ml/min.
   (f) depositing the target material on the substrates by means of magnetron sputtering by generating a plasma by applying a discharge potential with a power between 50 W and 300 W in radio frequency (RF) or continuous mode (DC), maintaining the working gas flow established in step (e), and the working pressure reached in step (d),
   (g) and removing the shutter from the deposition chamber if it is inserted, maintaining the deposition for periods that can go from 1 to 6 h, depending on the target material to be deposited and the working gas;
   (h) turning off the electric current applied in the previous step (f), maintaining the vacuum in the chamber (valve 3 closed and valve 2 open) for at least 12 h, and subsequently, slowly filling the chamber with Ar and O₂ and removing the solid material with gaseous aggregates.

In the present invention, "nanopore" is understood to be any closed pore in the final obtained material, the diameter of which is less than 100 nm. A closed pore is an occluded pore inside the material without communication with the external surface.

In the present invention, "magnetron cathode sputtering" is understood to be the technique known as "magnetron sputtering". It is a deposition method based on the intense bombardment of a target with the ions produced in an electrical discharge in the form of plasma. This bombardment causes the atoms of the target material to be stripped ("sputtering"), reaching the surface of a substrate wherein they condense growing a material.

This method is carried out in a generalised way with a continuous inlet of the working gas into the chamber, in equilibrium with continuous pumping, and maintaining the required working pressure in the so-called dynamic regime. This methodology produces the consequent expenditure of working gases.

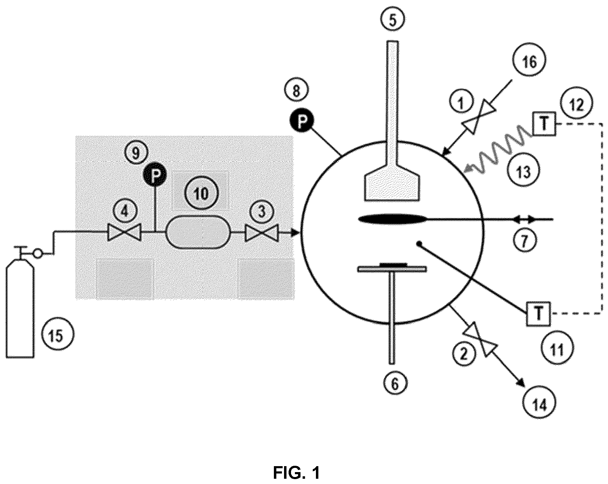

In the present invention, "static conditions or static equilibrium" are understood to be those in which the deposition by means of magnetron sputtering is carried out with the valves connected to the conduit of the working gas and to the conduit of the vacuum pump, and which in the present invention are respectively the valves 3 and 2 of Fig. 1, practically closed during the entire process with small adjustments to compensate for fluctuations in the internal pressure, so that the gas flow through these two valves is negligible compared to the total volume of gas in the chamber. The principle of this method is, therefore, to fill the chamber with a volume of working gas until reaching the determined pressure. A static equilibrium is established in the chamber and only this volume of gas is used. In the event of fluctuations in the internal pressure due to the sputtering process itself, due to thermal and other effects, they are also regulated with the valves connected to the gas tank and to the vacuum pump.

In the present invention, "quasistatic conditions or stationary equilibrium" are understood to be those in which the entire deposition process by means of magnetron sputtering is carried out with low flows, in other words, adjustable between 0.001 ml/min and a maximum of 0.1 ml/min at the inlet of the working gas while the working pressure is controlled by carefully opening the valve 3 to increase pressure and the valve 2 to lower it. In this way, it is possible to maintain the deposition conditions with minimum inlet or outlet flows, avoiding the constant renewal flow of the gas. In the event of fluctuations in the internal pressure due to the sputtering process itself, due to thermal and other effects, they are also regulated with the valves connected to the gas tank and to the vacuum pump.

The static (or quasistatic) equilibrium method requires several modifications to the conventional configuration of the magnetron sputtering device:
- Placement of a very fine control needle valve (valve 3, Fig. 1) at the gas inlet to the chamber. A second open-close valve can be optionally placed next to the needle valve for safety. The valve that controls the gas that comes out to the vacuum pump (valve 2, Fig. 1) is a component of the conventional set-up required in any working mode.
- Placement of a small volume tank for the working gas (tank in Fig. 1). This tank optimises the control of the use of gas but it can be optional.
- Introducing the automatic control of the working pressure by combining the signal from the pressure sensor (8 in Fig. 1) with the automatic control of the valves 2 and 3 (Fig. 1). This modification is optional, but it would make it possible to optimise the process by minimising the gas consumption.

In the present invention, "He gas or He" is understood to be the natural composition that mainly contains ⁴He.

In the present invention, ^{"3}He^{"} is understood to be the corresponding pure isotope.

In the present invention, ^{"4}He^{"} is understood to be the corresponding pure isotope.

In the present invention, "Ne gas or Ne" is understood to be the natural composition that mainly contains ²⁰Ne.

In the present invention, "²⁰Ne" is understood to be the corresponding pure isotope.

In the present invention, "²¹Ne" is understood to be the corresponding pure isotope.

In the present invention, "²²Ne" is understood to be the corresponding pure isotope.

In the present invention, "solid element to be used as a target" is understood to be any element that has a melting point greater than 500°C, wherein said temperature range is determined because the targets are going to be subjected to high temperatures by ionic bombardment during the deposition process, but at temperatures lower than said 500°C so that these elements remain in a solid state. In the present invention, said elements are selected, but without limitation, from Si, Cu, Co, Ti, Au, Al, W, Pt, Ta, B and C.

In a preferred embodiment, the method for obtaining a solid material with gaseous aggregates additionally comprises, after step (b) and prior to step (c), purging the chamber and the working gas inlet lines with emptying-filling cycles and final pressurisation of the lines. In this way, impurities and contaminants are efficiently eliminated in the gas lines to thus improve the quality of the material obtained by means of the present method.

In another preferred embodiment, the method for obtaining a solid material with gaseous aggregates further comprises an additional step of cleaning the target after step (c) and prior to step (d); to do this, a shutter is placed between the target and the sample holder, an Ar flow of 20 ml/min is introduced in the chamber up to a pressure between 4 Pa and 5.5 Pa, this flow is maintained for 5 min, and it is lowered to 5 ml/min, up to a pressure of 2 Pa. By applying a power to the magnetron between 150 and 250 W for a period between 0.4 h and 0.6 h, the target is cleaned prior to establishing the deposition conditions (static or quasistatic) and prior to starting the deposition with removal of the shutter. This additional cleaning is aimed at efficiently eliminating impurities and contaminants in the sputtering target and thus improving the quality of the material obtained by means of the present method.

In another preferred embodiment of the method of the present invention, two movable shutters configured to be placed between target and substrate are used, one just in front of the magnetron and the other on the substrate. This arrangement optimises the suppression of deposits on the substrate during the processes of cleaning the target and establishing the deposition conditions.

In another preferred embodiment of the method of the present invention, the working gas of step (d) is ³He. Working in static conditions minimises the use of expensive and scarce gases such as ³He and ²¹Ne. The manufacture of the solid targets of these elements, and the isotopes thereof, is not evident as they are noble gases that do not form bonds in solids. The present invention makes it possible to have these solid targets with advantages for use, for example, in neutron detectors or for the study of nuclear reactions.

In another preferred embodiment of the method of the present invention, the solid element used as target can be selected from Si, Cu, Co, Ti, Au, Al, W, Pt, Ta, B and C. In a more preferred embodiment, the solid element used as a target is Si. In another more preferred embodiment, the solid element used as a target is W.

In another preferred embodiment of the method of the present invention, the distance between the solid element to be used as a target and the sample holder is 10 cm in order to optimise the growth rate and the homogeneity of the layer.

In another preferred embodiment of the method of the present invention, the substrate of step (a) is NaCl, wherein the use of said NaCl substrate has the advantage that the final solid material with gaseous aggregates obtained is detached as a self-supported layer by loosening in water and can be subsequently supported on a frame.

In another preferred embodiment of the method of the present invention, in the event of fluctuations in the working pressure above 10%, said working pressure is adjusted to the desired value using the valve located in the inlet pipe of the working gas towards the deposition chamber to increase said working pressure and the valve connected to the outlet pipe towards the vacuum pump to reduce said working pressure. This method guarantees the homogeneity of the coating.

In another preferred embodiment of the method of the present invention, in step (d) the working gas is introduced in the deposition chamber from a tank located between the working gas cylinder and the deposition chamber and this tank is previously filled with the working gas. In this way, control over the use of gas is optimised.

In another preferred embodiment of the method of the present invention, in step (d) the working gas is introduced in the deposition chamber by means of automatic control of the working pressure by combining the signal from the pressure sensor with the automatic control of the valves. This makes it possible to optimise the process by minimising the working gas consumption.

In another preferred embodiment of the method of the present invention, in the event that the final solid material with gaseous aggregates is more than 1 µm thick, depending on the deposition rate of each material, the process can be carried out by repeating steps (d) to (f) during successive depositions, or in steps over several days, turning off the magnetron discharge at the end of each deposition. In a more preferred embodiment, cleaning of the target is performed prior to each step of filling the working gas in step (d), prior to starting each deposition, to optimise the elimination of impurities and improve the quality of the layer.

Throughout the description and the claims, the word "comprises" and its variants do not intend to exclude other technical features, additives, components or steps. For those skilled in the art, other objects, advantages and features of the invention may be partially deduced from both the description and the embodiment of the invention. The following examples and figures are provided by way of illustration and are not intended to limit the present invention.

### BRIEF DESCRIPTION OF THE FIGURES

**FIG. 1** shows a representative diagram of the experimental equipment designed for the deposition method in a static or quasistatic regime for low use of gas.
**FIG. 2** shows layers of Si and ⁴He grown at 150 W of power in RF mode, with working gas pressure of 5 Pa, with a distance of 10 cm between the target and the sample holder: (left) with a dynamic method for 10 hours and (right) with a static method for 3 hours.
**FIG. 3** shows layers of Si and ⁴He grown at 200 W of power in RF mode, with working gas pressure of 5 Pa, with a distance of 10 cm between the target and the sample holder for 5.5 hours: (left) with a dynamic method and (right) with a static method.
**FIG. 4** shows a layer of W and ³He grown on silicon substrate, for 10 hours using a quasistatic method, at 200 W of power in RF, at a working gas pressure of 5 Pa and with a distance of 10 cm between the target and the sample holder. On the left is a high-resolution micrograph obtained by means of transmission electron microscopy (TEM) showing different-sized pores containing the gas. Pores in TEM appear whiter in contrast.
**FIG. 5** shows a layer of Si and ³He grown on silicon substrate with SiC interlayer, for 12 hours using a quasistatic method, at 150 W of power in RF, at a working gas pressure of 5 Pa and with a distance of 10 cm between the target and the sample holder. On the right is an enlarged micrograph of scanning electron microscopy (SEM) showing the pores containing the gas.

### EXAMPLES

Next, the invention will be illustrated by means of assays carried out by the inventors which demonstrate the effectiveness of the product of the invention.

### Example 1

### Preparation of layers of W with He in static conditions

For illustrative purposes of the different components of the experimental system used, reference is made to the diagram depicted in FIG. 1 showing the different components and terms used throughout the description of the present invention.

The W target is placed in the chamber 10 cm away from the sample holder with silicon substrates, and metal sheets. A vacuum is created in the chamber to 10⁻⁵ Pa as well as in the gas lines if necessary, with the knife gate valve (2) fully open. Next, raise the pressure up to 8 Pa with Argon (16), lower the pressure to at least 10⁻⁴ Pa, and repeat 3 times. The pressure is lowered to the minimum for 24 h and then the chamber is heated up to 110°C with the help of a heater (13) and controlling the temperature with the temperature sensors (11-12) for 7 h and subsequently allowing it to cool completely.

Place the shutter (7) in position between the target and the sample holder and establish an Ar flow of 12 ml/min up to a pressure of 5 Pa, this flow is maintained for 5 min, and it is lowered to 5 ml/min, up to a pressure of 2 Pa. Turn on the plasma with a discharge current at 200 W RF power and thus clean the target for 30 min.
Turn off the discharge and cut off the Ar flow, lowering the pressure to 10⁻⁴ Pa.

Subsequently, a static pressure of 5 Pa is established, measured with a pressure sensor (8), entering the working gas (15) by controlling valve and closing the knife gate valve (2). The ball valve (4) has been previously opened and the working gas has been introduced in a tank (10), which is a 50 ml tank, wherein it is checked with another pressure sensor (9). Subsequently, with both the valve (3) and the knife gate valve (2) practically closed during the entire process, the desired pressure is established in the deposition chamber.

Apply a discharge current of 200 W in RF to turn on the plasma at the magnetron furnished with the target (5). If the plasma does not turn on, add a small volume of Ar until reaching a pressure in the chamber of 6-7 Pa, carefully opening and closing the valve (1) of the Ar line (16) (with the remaining pressure in the line) and apply the discharge current again. Raise the pressure with the working gas to 8-9 Pa with the needle valve (3), then lower it to 4 Pa and raise it again, repeating this cycle from 5 to 10 times until the colour of the plasma is completely green-white, moment in which the desired working pressure is established, keeping the shutter inserted.

To start the deposition process, the shutter (7) is removed from between the target and the sample holder (6), regulating the pressure with the needle valve (3) (raise) and the knife gate valve (2) (lower) to the pre-set value at 5 Pa in case of fluctuations.

If it is a long-term deposition, the time is divided into several days, repeating the process every day from when the shutter is placed prior to starting the deposition.
To end the deposition, turn off the plasma, close the needle valve (3) and fully open the knife gate valve (2) and wait a minimum of 12 h before flooding the chamber with Argon to remove the sample.

### Example 2

### Comparison example: Preparation of layers of W with He in dynamic conditions

Initial method the same as in the static process.

The target is cleaned with Ar as in static with the shutter in position between the target and the sample holder.

The plasma and the Ar flow are turned off, lowering the pressure to 10⁻⁴ Pa.

A dynamic pressure of He at 5 Pa is established with the gas inlet of up to 120 ml/min with the valve (3) open and the knife gate valve (2) partially open to control the outlet. The plasma is turned on by applying a discharge current at a power of 200 W RF. If it does not turn on, add a small volume of Ar and stabilise by removing all the Ar slowly. Maintain the He plasma with shutter closed for 30 min to complete cleaning of the target and elimination of traces of Ar.

Set the growth conditions of 60 ml/min of He inlet and pressure control at 5 Pa with the knife gate valve (2) partially open.

To start the deposition process, the shutter is removed from between the target and the sample holder, maintaining the growth conditions for the desired period.

To end the deposition, turn off the plasma, close the valve (3) and fully open the knife gate valve (2) and wait a minimum of 12 h before flooding the chamber with Argon to remove the sample.

### Example 3.

### Comparison example of the fabrication rate and composition for the silicon materials with He as obtained with the static and dynamic deposition processes

Deposition of silicon layers with He have been carried out in static and dynamic regimes with equal target material, power, gas and working pressure conditions. A conventional bottle of He was used, which is therefore mostly ⁴He. A comparative study of the growth rate, He content and impurity level has been carried out as described below.

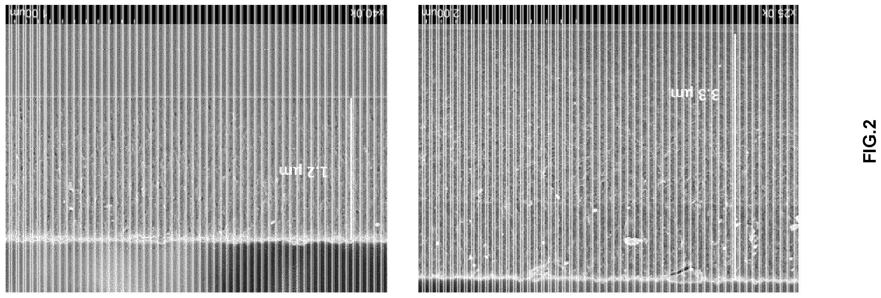

A layer was grown in dynamic conditions following the method described in Example 2 under the following conditions: Si target, working pressure of 5Pa, magnetron power of 150W in RF, working distance of 10 cm, deposition time of 10 hours. The resulting layer is shown in Fig. 2 (left). The thickness of the layer was determined by means of scanning electron microscopy (SEM), resulting in a growth rate of 5.5 nm/min. The incorporation of He and the impurities present have been determined by means of IBA analysis (characterisation with ion beams), atomic ratios of He/Si=0.5 and O/Si=0.09 being found. Other impurities far below the oxygen values have been found: Fe/Si=0.01, C/Si=0.006, N/Si=0.01.

A layer was grown in static conditions following the method described in Example 1 under the following conditions: Si target, working pressure of 5Pa, magnetron power of 150W in RF, working distance of 10 cm, deposition time of 3 hours. The resulting layer is shown in Fig. 2 (right). The thickness of the layer was determined by means of scanning electron microscopy (SEM), resulting in a growth rate of 6.5 nm/min. The incorporation of He and the impurities present have been determined by means of IBA analysis (characterisation with ion beams), atomic ratios of He/Si=0.6 and O/Si=0.08 being found. Other impurities far below the oxygen values have been found: Fe/Si=0.01. The C and N contents have been determined below 2 %at.

Working in static, all things being equal, leads to improvements in the growth rate, which favours the low gas consumption. Likewise, comparable (even higher) He content values are obtained while the impurity contents remain similar and in some cases improvements have been made, reducing the amount of oxygen.

### Example 4.

### Comparison example of the fabrication rate for the tungsten materials with He as obtained with the static and dynamic deposition processes

Deposition of tungsten layers with He have been carried out in static and dynamic regimes with equal target material, power, gas and working pressure conditions. A conventional bottle of He was used, which is therefore mostly ⁴He. A comparative study of the growth rate has been carried out.

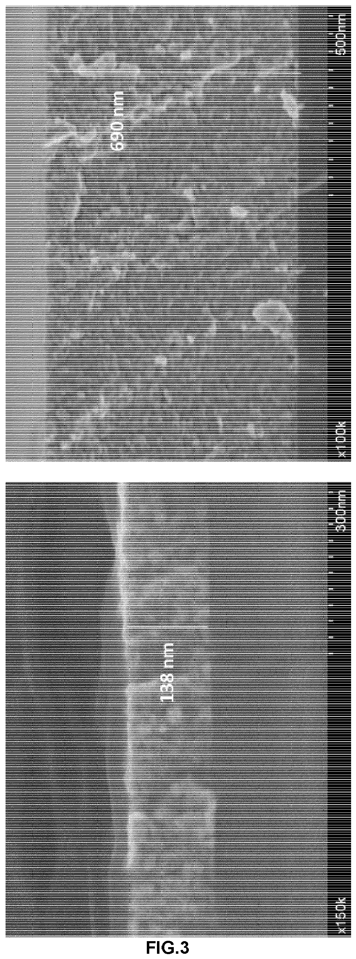

A layer was grown in dynamic conditions following the method described in Example 2 under the following conditions: W target, working pressure of 5Pa, magnetron power of 200W in RF, working distance of 10 cm, deposition time of 5.5 hours. The resulting layer is shown in Fig. 3 (left). The thickness of the layer was determined by means of scanning electron microscopy (SEM), resulting in a growth rate of 0.4 nm/min.

A layer was grown in static conditions following the method described in Example 1 under the following conditions: W target, working pressure of 5Pa, magnetron power of 200W in RF, working distance of 10 cm, deposition time of 5.5 hours. The resulting layer is shown in Fig. 3 (right). The thickness of the layer was determined by means of scanning electron microscopy (SEM), resulting in a growth rate of 2 nm/min.

Working in static under equal conditions leads to very important improvements in the growth rate, which favours the low gas consumption.

### Example 5.

### Manufacturing example of a tungsten layer containing ³He in a quasistatic process of low consumption of gas

Given the importance of the working method for the low use of gas for gases that are scarce and very expensive but of great strategic relevance such as ³He, an exemplary embodiment of the invention is presented for the case of a tungsten layer containing ³He. The solid target of W:³He would have application for studies in nuclear physics and for neutron detectors.

A layer was grown in quasistatic conditions following the general method described under the following conditions: W target, silicon substrate, working pressure of 5Pa for ³He gas, magnetron power of 200W in RF, working distance of 10 cm, deposition time of 10 hours. Throughout the entire deposition process, flows were always below 0.1 ml/min at the working gas inlet while the working pressure is controlled by carefully opening the valve 3 to increase the pressure and the valve 2 to decrease it.

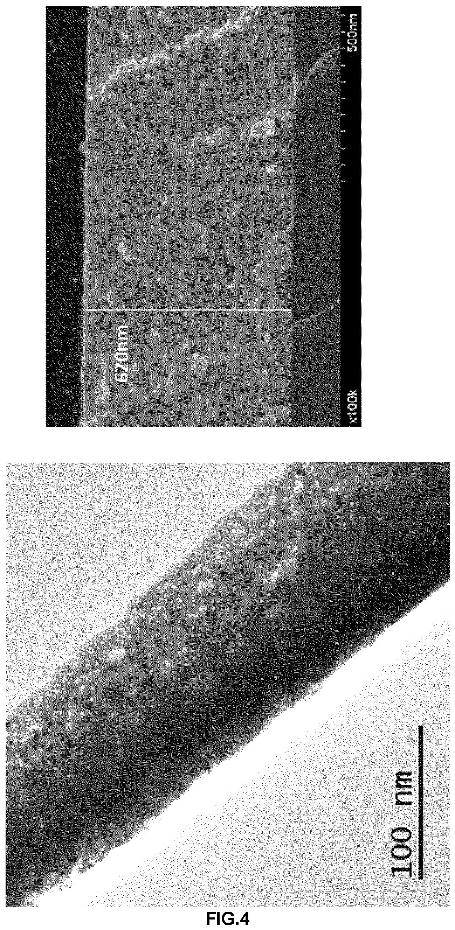

The microstructure of the layer has been studied by means of transmission electron microscopy (TEM) and scanning electron microscopy (SEM). Fig. 4 shows two representative micrographs wherein the porous structure of the coating can be observed. A thickness of 620 nm has been obtained, note that this layer is grown with ³He instead of ⁴He so that the expected growth rate is lower than the one of the analogous layer grown with ⁴He. This solid target obtained has been characterised by the EBS and ERDA techniques (IBA techniques) resulting in an estimated gas mass thickness (³He) of 2.65x10¹⁷ at/cm² and metal mass thickness (W) of 23.45x10¹⁷ at/cm². This corresponds to an effective thickness of 1.33 µg/cm² of ³He. With regard to impurities, this sample contains 2.3 at% of ⁴He and has atomic ratios O/W=0.14; H/W=0.17; C/W=0.05 and N/W=0.0

This sample has been irradiated with a beam of ⁶⁴Zn at 275 MeV with an intensity of 5 pnA for 12 hours without significant visual sign of damage in the sample.

### Example 6.

### Manufacturing example of a silicon layer containing ³He in a quasistatic process for a low consumption of gas.

Given the importance of the working method for the low use of gas for gases that are scarce and very expensive but of great strategic relevance such as ³He, an exemplary embodiment of the invention is presented for the case of a silicon layer containing ³He. The solid target of Si:³He would have application for studies in nuclear physics and for neutron detectors.

A layer was grown in quasistatic conditions following the general method described under the following conditions: Si target, Si substrate with SiC interlayer, working pressure of 5Pa for ³He gas, magnetron power of 150W in RF, working distance of 10 cm, deposition time of 12 hours. Throughout the entire deposition process, flows were always below 0.1 ml/min at the working gas inlet while the working pressure is controlled by carefully opening the valve 3 to increase the pressure and the valve 2 to decrease it.

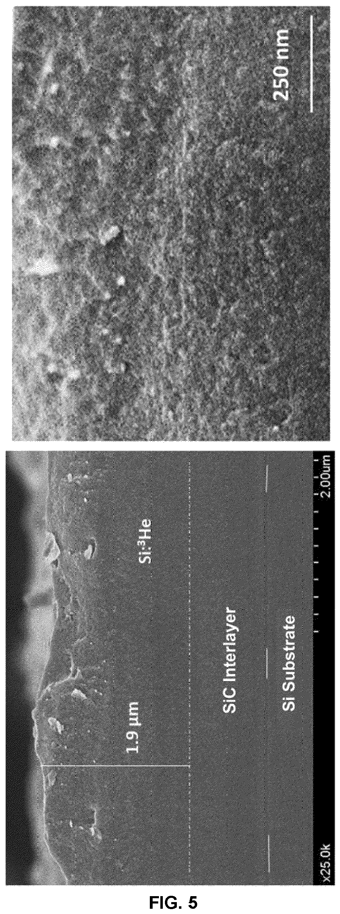

The microstructure of the layer has been studied by means of scanning electron microscopy (SEM). Fig. 5 shows two representative micrographs wherein the porous structure of the coating can be observed. A thickness of 1.9 µm has been obtained, note that this layer is grown with ³He instead of ⁴He so that the expected growth rate is lower than the one of the analogous layer grown with ⁴He. This solid target obtained has been characterised by the EBS technique (IBA technique), resulting in an estimated gas mass thickness (³He) of 1.28x10¹⁸ at/cm² and matrix mass thickness (Si) of 6.38x10¹⁸ at/cm². This corresponds to an effective thickness of 6.4 µg/cm² of ³He. With regard to impurities, this sample contains 2.0 at% of ⁴He and has atomic ratios O/Si=0.0 and C/Si=0.04

## Claims

1. A method for obtaining a solid material with gaseous aggregates wherein said aggregates are embedded inside nanopores and/or in the grain boundaries of the solid, by means of magnetron cathode sputtering in static or quasistatic conditions, **characterised in that** it is carried out in a deposition chamber comprising
• a magnetron, located in the upper area of the deposition chamber and configured to generate a controllable magnetic field;
• a target, attached to the magnetron, configured to house a solid element to be used as a target;
• a sample holder, located at a distance between 8-10 cm from the target, configured so that a substrate is on it;
• a shutter located between the target and the sample holder and configured to move transversely along the direction between the target and the sample holder;
• a pressure sensor located on one of the sides of the chamber and configured to send a signal that indicates the internal pressure in the chamber;
• a valve located in an inlet pipe to the deposition chamber from a working gas cylinder, configured to control the flow of the working gas entering the deposition chamber;
• a valve connected to an outlet pipe to the vacuum pump, configured to control the gas that comes out to a vacuum pump;
and wherein said method comprises the following steps
(a) introducing a solid element to be used as a target in the magnetron cathode sputtering deposition chamber, and a substrate selected from silicon, NaCl, metal sheets, and SiC, on the sample holder;
(b) closing all the valves of the deposition chamber and creating a vacuum in the chamber after placing the solid as a target in step (a) up to a pressure of at least 1.10⁻⁴ Pa;
(c) heating the deposition chamber once the necessary vacuum has been reached in step (b) to a temperature between 80°C and 110°C for a time between 6 h and 8 h, and subsequently allowing it to cool down to a temperature between 10°C and 30°C;
(d) closing the valve connected to the vacuum pump of the chamber, introducing the working gas in the deposition chamber after the heating step (c) wherein said working gas is selected from ³He, ⁴He, He, ²⁰Ne, ²¹Ne, ²²Ne, Ne, H₂, N₂, Ar and any mixture of the foregoing up to a working pressure between 3 Pa and 7 Pa;
(e) once the pressure described in the previous step (d) has been reached, and maintaining said working pressure in the chamber, the working gas flow is reduced, fully or partially closing the inlet and outlet valves to and from the deposition chamber until reaching a flow selected from
• a flow of zero ml/min; or
• a flow between 0.001 ml/min and 0.1 ml/min;
(f) depositing the target material on the substrates by means of magnetron sputtering by generating a plasma by applying a discharge potential with a power between 50 W and 300 W in radio frequency (RF) or continuous mode (DC), maintaining the working gas flow established in step (e), and the working pressure reached in step (d);
(g) and removing the shutter from the deposition chamber if it is inserted, maintaining the deposition for periods that can go from 1 to 6 h, depending on the target material to be deposited and the working gas;
(h) turning off the electric current applied in the previous step (f), maintaining the vacuum in the chamber (valve 3 closed and valve 2 open) for at least 12 h, and subsequently, slowly filling the chamber with Ar and O₂ and removing the solid material with gaseous aggregates.

2. The method for obtaining a solid material with gaseous aggregates according to claim 1, **characterised in that** it further comprises a step after step (b) and prior to step (c) of purging the chamber and the working gas inlet lines with emptying-filling cycles and final pressurisation in the gas lines.

3. The method for obtaining a solid material with gaseous aggregates according to any of claims 1 or 2, **characterised in that** it further comprises an additional step of cleaning the target after step (c) and prior to step (d).

4. The method for obtaining a solid material with gaseous aggregates according to any of claims 1 to 3, wherein two movable shutters are used between target and substrate, one in front of the magnetron and the other on the substrate.

5. The method for obtaining a solid material with gaseous aggregates according to any of claims 1 to 4, wherein the working gas is ³He.

6. The method for obtaining a solid material with gaseous aggregates according to any of claims 1 to 5, wherein the solid element used as a target in step (a) is selected from Si, Cu, Co, Ti, Au, Al, W, Pt, Ta, B and C.

7. The method for obtaining a solid material with gaseous aggregates according to claim 6, wherein the solid element used as a target in step (a) is Si.

8. The method for obtaining a solid material with gaseous aggregates according to claim 6, wherein the solid element used as a target in step (a) is W.

9. The method for obtaining a solid material with gaseous aggregates according to any of claims 1 to 8, wherein the distance between the target and the sample holder is 10 cm.

10. The method for obtaining a solid material with gaseous aggregates according to any of claims 1 to 9, wherein the substrate located on the sample holder in step (a) is NaCl.

11. The method for obtaining a solid material with gaseous aggregates according to any of claims 1 to 10, wherein in step (d) the working gas is introduced in the deposition chamber from a tank located between the working gas cylinder and the deposition chamber and this tank has been previously filled with the working gas.

12. The method for obtaining a solid material with gaseous aggregates according to any of claims 1 to 11, wherein in step (d) the working gas is introduced in the deposition chamber by means of automatic control of the working pressure by combining the signal from a pressure sensor and by means of automatic control of the valves.

13. The method for obtaining a solid material with gaseous aggregates according to any of claims 1 to 12, wherein the final solid material with gaseous aggregates is more than 1 µm thick, the process can be carried out by repeating steps (d) to (f) during successive depositions turning off the magnetron discharge potential at the end of each deposition.

14. The method for obtaining a solid material with gaseous aggregates according to claim 13, wherein cleaning of the target is performed prior to each step of filling of the working gas (d) for starting each deposition.
